# EUROPEAN PATENT APPLICATION

(11) **EP 2 706 315 A2**
(43) Date of publication of application: **12.03.2014**
(21) Application number: 13181291.9
(22) Date of filing: 22.08.2013
(51) Int. Cl.: F25D 17/02

(54) **Cooling system**

(30) Priority: 07.09.2012 JP 2012197274
(71) Applicant: FUJITSU LIMITED, Kawasaki-shi, Kanagawa 211-8588 (JP)
(72) Inventor: WAJIMA, Eiji, Kawasaki-shi, Kanagawa 211-8588 (JP)
(74) Representative: Lewin, David Nicholas

(57) **Abstract**

A cooling system (1) includes a first pump group (10) inclu ding a plurality of pumps (11-16) that circulates a cooling mediu m to cool a first part; a second pump group (20) including a plur ality of pumps (21-26) that circulates a cooling medium to cool a second part; a first power supply (31) that supplies electric power to a part (11-13) of the pumps of the first pump group (10) and a part (21-23) of the pumps of the second pump group (20) ; and a sec ond power supply (32) that supplies electric power to another part (14-16) of the pumps of the first pump group and another part (24 -26) of the pumps of the second pump group.

## Description

### FIELD

The embodiment discussed herein is related to a cooling system including a pump group that circulates a cooling medium to cool a part.

### BACKGROUND

Conventionally, a cooling system that circulates a cooling medium by a pump for a cooling target has been known (for example, see Japanese Laid-open Patent Publication No. 56-81287 and No. 2010-211363).

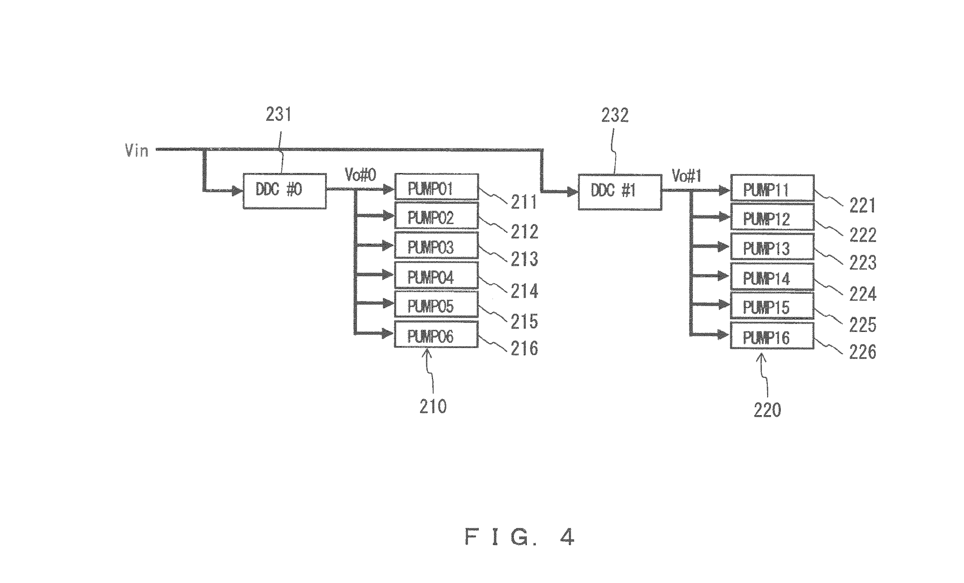

FIG. 4 is a diagram illustrating a pump power supply configuration of a cooling system according to a reference art.

In a cooling system illustrated in FIG. 4, a first pump group 210 includes first-sixth pumps 211-216 (PUMP01-06) that circulate a cooling medium to cool the first part not illustrated in the drawing. Meanwhile, a second pump group 220 includes first-sixth pumps 221-226 that circulate a cooling medium to cool the second part not illustrated in the drawing.

A first power supply 231 (DDC #0:DC-DC converter) supplies electric power to the pumps 211-216 of the first pump group. A second power supply 232 (DDC #1:DC-DC converter) supplies electric power to the pumps 221-226 of the second pump group 220.

### SUMMARY

Accordingly, it is an object in one aspect of the embodiment to provide a cooling system that is capable of extending the time until a part cooled by a cooling medium is broken at the time of power supply breakdown.

According to an aspect of the embodiment, a cooling system including a first pump group including a plurality of pumps that circulates a cooling medium to cool a first part; a second pump group including a plurality of pumps that circulates a cooling medium to cool a second part; a first power supply that supplies electric power to a part of the pumps of the first pump group and a part of the pumps of the second pump group; and a second power supply that supplies electric power to another part of the pumps of the first pump group and another part of the pumps of the second pump group is provided.

### BRIEF DESCRIPTION OF DRAWINGS

FIG.1 is an apparatus configuration diagram of a cooling system according to an embodiment.
FIG. 2 is a power supply configuration diagram of a cooling system according to an embodiment.
FIG. 3 is a graph for explaining an increase in the cooling medium temperature with respect to the time after a power supply breakdown in the embodiment.
FIG. 4 is a power supply configuration diagram of a cooling system according to a reference art.

### DESCRIPTION OF EMBODIMENT

In a pump power supply configuration of the cooling system according to the reference art illustrated in FIG. 4 described above, when the first power supply 231 or the second power supply 232 has a breakdown and the output power supply is lost, it leads to a situation where all the pumps of the first pump group 210 or the second pump group 220 stop. Therefore, there is a problem that, when power supply is continued to the heat-generating element of the stopped circulation cooling system, boiling occurs in a short period of time and breaks the heating-element body.

It is possible to prevent the breakage of the circulation cooling system by stopping the power supply to the heat-generating element in a short time by monitoring the number of pump rotations and detecting the power supply breakdown. However, in a server apparatus for example, sudden stopping of a heat-generating part (a CPU and the like) leads to loss of processing data and destruction of data of the HDD (Hard Disk Drive) apparatus. In such a case, there is a problem that it leads to a decrease in the system reliability.

Hereinafter, a cooling system according to an embodiment is explained with reference to the drawings.

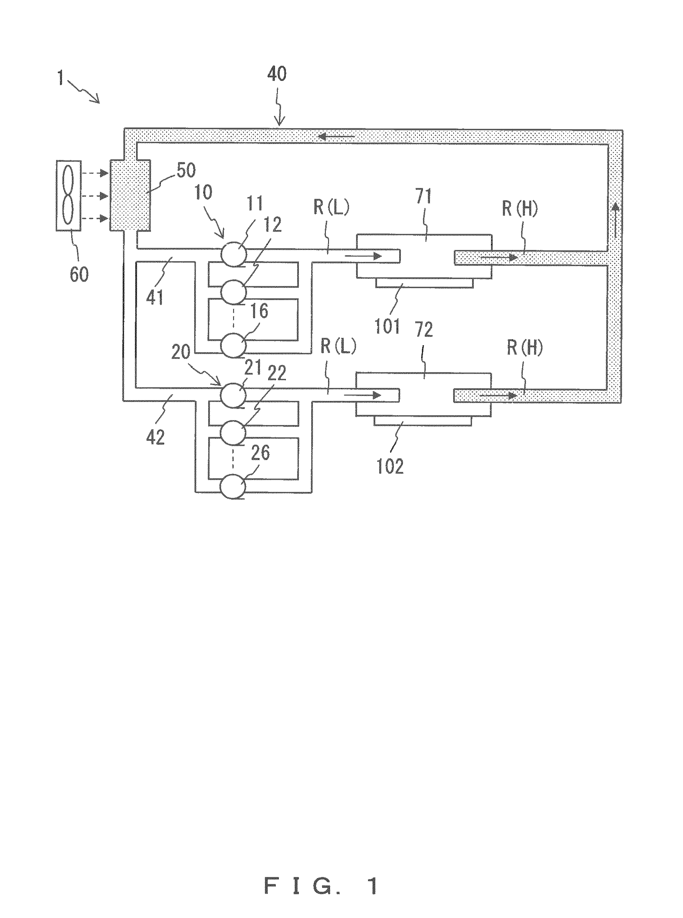

FIG. 1 is an apparatus configuration diagram of a cooling system 1 according to the present embodiment.

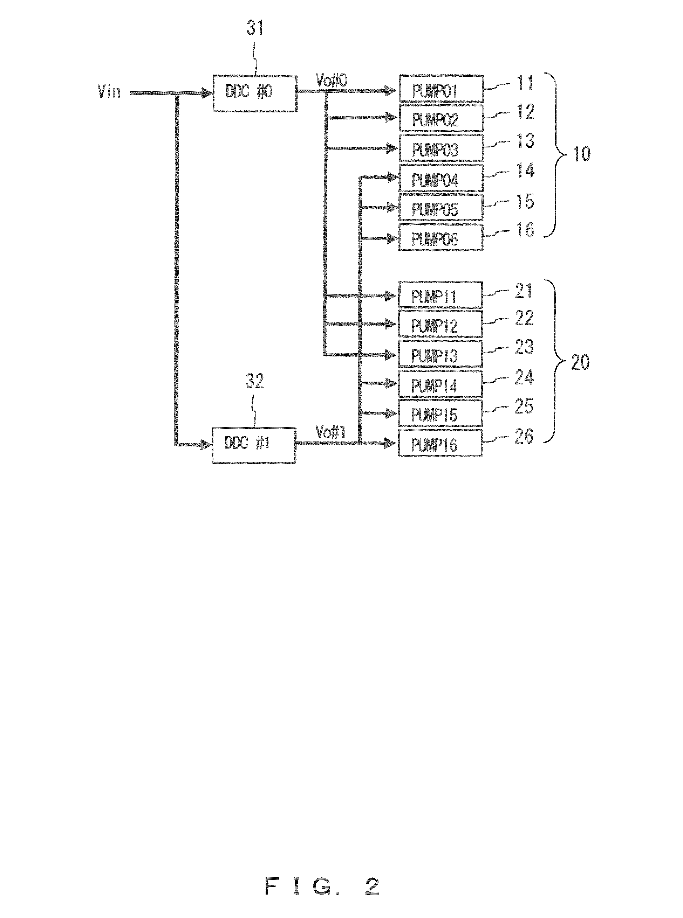

FIG. 2 is a power supply configuration diagram of a cooling system 1 according to the present embodiment.

The cooling system 1 includes a first pump group 10, a second pump group 20, a first power supply 31, a second power supply 32, a circulation path 40, a heat exchanger 50, a fan 60, a first heat receiving unit 71 and a second heat receiving unit 72.

The first pump group 10 includes first-sixth 6 pumps 11-16 being six units (an example of a plurality) of pumps. While the details are described later, the first-sixth pumps 11-16 of the first pump group 10 circulates a cooling medium R to cool a first part 101 of which example is a heat-generating part such as a CPU mounted on a circuit board in the circulation path 40.

In a similar manner, in the second pump group 20, first-sixth pumps 21-26 being six units (an example of a plurality) of pumps circulate a cooling medium R to cool a second part 102 of which example is a heat-generating part such as a CPU mounted on a circuit board in the circulation path 40.

The first pump group 10 and the second pump group 20 may be mounted on a circuit board on which the first part 101 and the second part 102 are mounted.

As illustrated in FIG. 2, a first power supply 31 (DDC #0:DC-DC converter) supplies electric power (Vo#0) to first-third pumps 11-13 (PUMP01-03) being an example of a part of pumps of the first pump group 10, and first-third pumps 21-23 (PUMP 11-13) being an example of a part of pumps of the second pump group 20.

A second power supply 32 (DDC #1:DC-DC converter) supplies electric power (Vo#1) to a fourth-sixth pumps 14-16 (PUMP04-06) being an example of other pumps of the first pump group 10, and fourth-sixth pumps 24-26 (PUMP 24-26) being an example of other pumps of the second pump group 20.

The circulation path 40 forms a flow path to let the cooling medium R go through the first pump group 10, the second pump group 20, and a first heat receiving unit 71 that receives heat generated from the first part 101, and a second heat receiving unit 72 that receives heat generated from the second part 102.

The circulation path 40 branches into a branch path 41 that goes through the first heat receiving unit 71 and a second branch path 42 that goes through the second heat receiving unit 72, being an example of a plurality of branch paths. The branching position is, preferably, on the way from the heat exchanger 50 towards the first part 101 and the second part 102.

The first pump group 10 is arranged in parallel in the first branch path 41, and the second pump group 20 is arranged in parallel in the second branch path 42. The first branch path 41 and the second branch path 42 of the circulation path 40 merges after going through the first heat receiving unit 71 and the second heat receiving unit 72, respectively, and form a flow path that leads to the heat exchange 50.

The first pump group 10 is located, in the first branch path 41, between the heat exchanger 50 and the heat receiving unit 71. Meanwhile, the second pump group 20 is located, in the second branch path 42, between the heat exchanger 50 and the second heat receiving unit 72.

The heat exchanger 50 releases the heat of the cooling medium R by air blow from a fan 60, for example. The cooling medium is a fluid for example.

The first heat receiving unit 71 is provided on the first part 101, and receives heat generated from the first part 101. The first part 101 is cooled with the first heat receiving unit 71 being cooled by the cooling medium R of the first branch path 41 of the circulation path 40.

The second heat receiving unit 72 is provided on the second part 102, and receives heat generated from the second part 102. The second part 102 is cooled with the second heat receiving unit 72 being cooled by the cooling medium R of the second branch path 42 of the circulation path 40.

According to this, the low-temperature cooling medium R (L) of which heat is released by the heat exchanger 50 becomes the high-temperature cooling medium R (H) represented by halftone dots in FIG. 1 by heat transfer from the first heat receiving unit 71 and the second heat receiving unit 72.

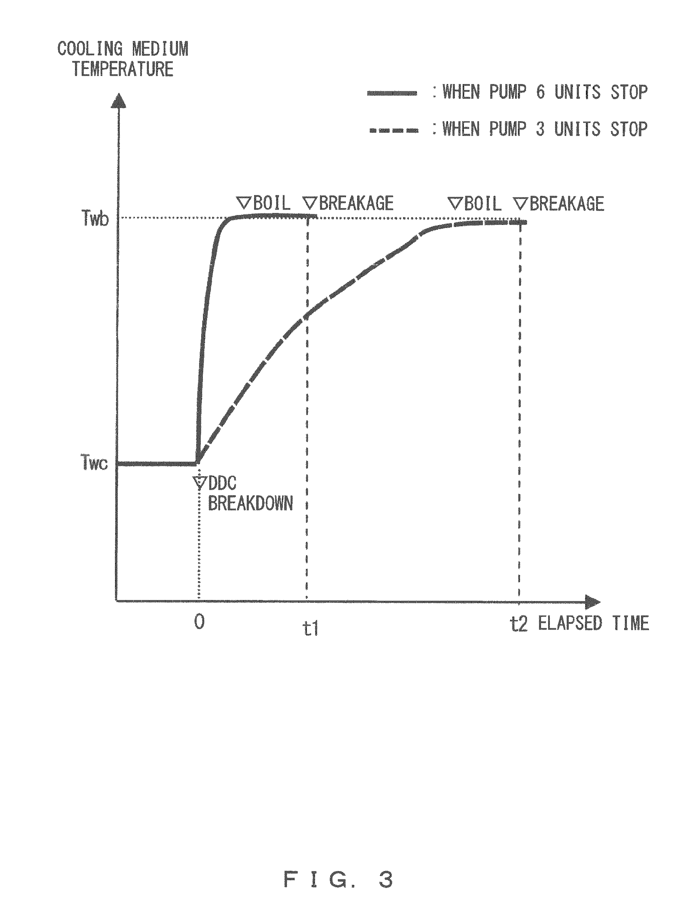

FIG. 3 is a graph for explaining an increase in the cooling medium temperature with respect to the time after a power supply breakdown in the embodiment.

First, as in the cooling system according to the reference art (comparison example) illustrated in FIG. 4, a case in which the first power supply 231 supplies electric power to all the pumps 211-216 of the first pump group 210, and the second power supply 232 supplies electric power to all the pumps 221-226 of the second pump group 220 is considered. Meanwhile, the first pump group 210 circulates a cooling medium in the first part not illustrated in the drawing, and the second pump group 220 circulates a cooling medium in the second part not illustrated in the drawing.

In the case of this reference art, when the first power supply 231 or the second power supply 232 (DDC in FIG. 3) has a breakdown, all the pumps of the first pump group 10 or the second pump group 20. Therefore, as indicated by a solid line in FIG. 3 (WHEN PUMP 6 UNITS STOP), the cooling medium temperature Twc before the breakdown rises rapidly and soon reaches the boiling temperature Twb, and a breakage occurs in the part being the cooling target in t1 time after the power supply breakdown.

Next, as in the cooling system 1 according to the present embodiment illustrated in FIG. 1 and FIG. 2, a case in which the first power supply 31 supplies electric power to a part of pumps 11-13 of the first pump group 10 and a part of pumps 21-23 of the second pump group 20, and the second power supply 32 supplies electric power to another part of pumps 14-16 of the first pump group 10 and another part of pumps 24-26 of the second pump group 20 is considered.

In this case of the present embodiment, even when the first power supply 31 or the second power supply 32 (DDC in FIG. 3) has a breakdown, only a part (three units in the present embodiment) of pumps of the first pump group 10 or the second pump group 20 stop. Therefore, as indicated by a broken line in FIG. 3 (WHEN PUMP 3 UNITS STOP), the cooling medium temperature Twc before the breakdown rises moderately and reaches the boiling temperature Twb, and no breakage occurs in the first part 101 or the second part 102 being the cooling target until t2 time that is twice the length of t1 time in the comparison example.

As described above, when the first power supply 31 and the second power supply 32 have a breakdown, the breakage of the first part 101 and the second part 101 may be delayed with a fewer number of pumps stopped. Therefore, it is preferable that the number of pumps (in the present embodiment, three units) of the first pump group 10 to which the first power supply 31 supplies electric power and the number of pumps (in this example, three units) of the second pump group 20 to which the first power supply 31 supplies electric power are the same or different by one.

Meanwhile, it is preferable that the number of pumps (in the present embodiment, three units) of the first pump group 10 to which the second power supply 32 supplies electric power and the number of pumps (in this example, three units) of the second pump group 20 to which the second power supply 32 supplies electric power are the same or different by one.

Accordingly, when the first power supply 31 and the second power supply 32 have a breakdown, the maximum value of the number of stopped pump units in the first pump group 10 and the second pump group 20 may be reduced, and the breakage of the first part 101 and the second part 102 may be delayed.

In the present embodiment described above, the first pump group 10 includes a plurality of pumps 11-16 that circulate the cooling medium R to cool the first part 101, and the second pump group 20 includes a plurality of pumps 21-26 that circulate the cooling medium R to cool the second part 102. The first power supply 31 supplies electric power to a part of pumps 11-13 of the first pump group 10 and a part of pumps 21-23 of the second pump group 20. The second power supply 32 supplies electric power to another part of pumps 14-16 of the first pump group 10 and another part of pumps 24-26 of the second pump group 20.

Accordingly, it is possible to prevent the stop of all the pumps of the first pump group 10 and or the second pump group 20 when the first power supply 31 or the second power supply 32 has a breakdown, and to suppress the rapid rise of the temperature of the temperature of the cooling medium R, and thus the temperature of the part 101 and the part 102.

Therefore, according to the present embodiment, the time at the time of breakdown of the first power supply 31 or the second power supply 32 until the first pat 101 and the second part 102 cooled by the cooling medium R are broken may be extended. Accordingly, the reliability of the cooling system 1 improves, as, for example, the first part 101 and the second part 102 may be stopped safely using the extended time. In addition, since the reliability of the cooling system 1 may be improved without making the power supply redundant, the layout space of mounted parts is increased, and high-density mounting also becomes possible.

Meanwhile, in the present embodiment, the circulation path 40 forms a flow path to let the cooling medium R go through the first pump group 10, the second pump group 20, the first heat receiving unit 71 and the second heat receiving unit 72, and branches into a plurality of branch paths including the first branch path 41 that goes through the first heat receiving unit 71, and the second branch path 42 that goes through the second heat receiving unit 72. The first pump group 10 is arranged in parallel in the first branch path 41, and the second pump group 20 is arranged in parallel in the second branch path 42. Therefore, the time until the first part 101 and the second part 102 are broken may be extended with a simple configuration. Therefore, a higher-density mounting is also possible.

Meanwhile, in the present embodiment, the circulation path 40 branches into a plurality of branch paths 41, 42 on the way from the heat exchanger 50 towards the first heat receiving unit 71 and the second heat receiving unit 72. The first pump group 10 is located between the heat exchanger 50 and the first heat receiving unit 71, and the second pump group 20 is located between the heat exchanger 50 and the second heat receiving unit 72. For this reason, the first pump group 10 and the second pump group 20 are able to circulate the cooling medium R at the position where the low-temperature cooling medium R(L) of which heat is released by the heat exchanger 50 goes through, and the durability of the first pump group 10 and the second pump group 20 may be improved. Therefore, the reliability of the cooling system 1 is further improved.

Meanwhile, in the present embodiment, the number of pumps of the first pump group 10 to which the first power supply 31 supplies electric power and the number of pumps of the second pump group 20 to which the first power supply 31 supplies electric power are the same (or different by one). The number of pumps of the first pump group 10 to which the second power supply 32 supplies electric power and the number of pumps of the second pump group 20 to which the second power supply 32 supplies electric power are the same (or different by one). For this reason, when the first power supply 31 and the second power supply 32 have a breakdown, the maximum value of the number of stopped pump units in the first pump group 10 and the second pump group 20 may be reduced, and the time until the first part 101 and the second part 102 are broken may be extended.

Meanwhile, in the present embodiment, the cooling system 1 includes two pump groups in total, the first pump group 10 that circulates the cooling medium R to cool the first part 101 and the second pump group 20 that circulate the cooling medium R to cool the second part 102. However, the cooling system 1 may also be configured to include three or more pump groups such as a third pump group that circulates the cooling medium R to cool a third part.

Meanwhile, while the cooling system 1 includes the first power supply 31 and the second power supply 32 in the present embodiment, three or more power supplies may be included such as a third power supply that supplies a part of pumps of the first pump group 10 and a part of pumps of the second pump group 20.

Meanwhile, while the number of power supplies 31, 32 is the same as the number of the pump groups 10, 20, the number of the power supplies may be larger than the number of the pump groups, and vice versa, the number.

## Claims

1. A cooling system comprising:
a first pump group (10) comprising a plurality of pumps (11 -16) that circulates a cooling medium to cool a first part;
a second pump group (20) comprising a plurality of pumps (2 1-26) that circulates a cooling medium to cool a second part;
a first power supply (31) that supplies electric power to a part of the pumps of the first pump group and a part of the pumps o f the second pump group; and
a second power supply (32) that supplies electric power to another part of the pumps of the first pump group and another part
of the pumps of the second pump group.

2. The cooling system according to claim 1, further comprising:
a first heat receiving unit (71) that receives heat generated from the first part;
a second heat receiving unit (72) that receives heat generated from the second part; and
a circulation path (40) that forms a flowpath to let the cooling medium go through the first pump group, the second pump group, the first heat receiving unit and the second heat receiving unit; wherein
the circulation path branches into a plurality of branch paths including a first branch path (41) going through the first heat receiving unit and a second branch path (42) going through the second heat receiving unit;
the first pump group is arranged in parallel in the first branch path; and
the second pump group is arranged in parallel in the second branch path.

3. The cooling system according to claim 2, further comprising a heat exchanger (50) that releases heat of the cooling medium, wherein
the circulation path branches into the plurality of branch paths on a way from the heat exchanger to the first heat receiving unit and the second receiving unit;
the first pump group is located between the heat exchanger and the first heat receiving unit; and
the second pump group is located between the heat exchanger and the second heat receiving unit.

4. The cooling system according to one of claims 1, 2, and 3, wherein
a number of the pumps of the first pump group to which the first power supply supplies electric power and a number of the pumps of the second pump group to which the first power supply supplies electricity is same of different by one; and
a number of the pumps of the first pump group to which the second power supply supplies electric power and a number of the pumps of the second pump group to which the second power supply supplies electricity is same of different by one.
